# EUROPEAN PATENT APPLICATION

(11) **EP 3 223 424 A1**
(43) Date of publication of application: **27.09.2017**
(21) Application number: 17162145.1
(22) Date of filing: 21.03.2017
(51) Int. Cl.: H02P 29/024, G01R 31/42

(54) **MOTOR DRIVE, HARNESS, AND MOTOR FAULT DETECTION FOR A MULTI-CHANNEL ELECTRIC BRAKE ACTUATOR CONTROLLER**

(30) Priority: 21.03.2016 US 201615076285
(71) Applicant: Simmonds Precision Products, Inc., Vergennes, VT 05491 (US)
(72) Inventor: MASTROCOLA, Naison E., Goshen, CT 06756 (US); ABBOTT, Michael, Shelburne, VT 05482 (US); RICHARDSON, Brian L., Shelburne, VT 05482 (US)
(74) Representative: Hughes, Andrea Michelle

(57) **Abstract**

A system and a method of detecting and isolating a fault in an electric motor system are provided. The method includes detecting, at a motor drive electronics (MDE) component (110) that is configured to drive an electric motor (130) through a harnessing (120), the fault in the electric motor system, applying a voltage and current, at the MDE component, according to a gate switching sequence for all phases of the electric motor system in response to detecting the fault, sensing voltage and current values in the MDE component between switches of an inverter of the MDE component, and isolating the fault within the electric motor system based on the sensed voltage and current values.

## Description

### BACKGROUND

The subject matter disclosed herein generally relates to fault detection and, more particularly, to motor drive, harness, and motor fault detection for a multichannel electric brake actuator controller.

Modem aircraft utilize electric motors in a multitude of applications; pumps, compressors, actuators, starters, etc. Many of these applications require the relatively sensitive motor drive electronics (MDE) component be located in an environmentally controlled electronic equipment bay. In contrast, the electric motor is remotely located elsewhere on the airframe. Often a significant distance exists between the MDE component and the electric motor located elsewhere in the airframe. The reliability of this type of architecture is dependent on the airframe harnessing and its ability to deliver the signals between the MDE and the motor.

One such system is an aircraft's electric brake (eBrake) that includes eight actuators that are driven by a single MDE component. The eBrake and the MDE component are separated by roughly 30m (100 feet) of harness. Due to the number or parts, failure group ambiguity between the MDE, the Harness, and the Motor following a motor drive circuit fault may result in the incorrect removal of functioning system components. Accordingly, there is a need to provide a system and method for improving the detection of system faults.

### BRIEF DESCRIPTION

According to one embodiment, a method of detecting and isolating a fault in an electric motor system is provided. The method includes detecting, at a motor drive electronics (MDE) component that is configured to drive an electric motor through a harnessing, the fault in the electric motor system, applying a voltage and current, at the MDE component, according to a gate switching sequence for all phases of the electric motor system in response to detecting the fault, sensing voltage and current values in the MDE component between switches of an inverter of the MDE component, and isolating the fault within the electric motor system based on the sensed voltage and current values.

In addition to one or more of the features described above, or as an alternative, further embodiments may include wherein applying the voltage and current according to the gate switching sequence includes removing previous voltage and current across sensor detection points of sensors of the electric motor system in response to detecting the fault, and cycling the application of the voltage and current through gate drives of the switches of the inverter that corresponds to each phase of the electric motor system.

In addition to one or more of the features described above, or as an alternative, further embodiments may include wherein if a voltage value of zero is sensed it is indicative of an open phase or failure of a switch of the inverter to turn on, and wherein if current is sensed and exceeds a ground fault limit (GFI), it is indicative of a gross ground fault.

In addition to one or more of the features described above, or as an alternative, further embodiments may include wherein applying the voltage and current according to the gate switching sequence includes holding a single switch of the inverter on for an extended period to sense low level GFI, and closing the current loop for each phase one at a time using the other switches of the inverter, wherein the holding and closing is done for all combination of switches and phases.

In addition to one or more of the features described above, or as an alternative, further embodiments may include wherein isolating the fault based on the sensed voltage and current values further includes analyzing the sensed voltage and current values compared to known voltage and current values during a faultless normal operation state of the electric motor system, deriving differences between the sensed voltage and current values and the known voltage and current values based on the analysis, and looking up the differences in a truth table stored in the electric motor system that indicated fault location possibilities based on the detected differences.

In addition to one or more of the features described above, or as an alternative, further embodiments may include wherein removing voltage and current across sensor detection points includes sensor zeroing that includes removing the voltage and current from all gates in the MDE component, and removing the voltage and current from all sensors in the electric motor system.

In addition to one or more of the features described above, or as an alternative, further embodiments may include replacing a line replaceable unit (LRU) of the electric motor system in response to the isolating of the fault being isolated to the LRU.

In addition to one or more of the features described above, or as an alternative, further embodiments may include, wherein the electric motor system is included in an aircraft.

According to another embodiment, an electric motor system for detecting and isolating a fault is provided. The system includes a motor drive electronic (MDE) component including an inverter with a plurality of switches configured to switch between phases, an electric motor connected to the MDE component, wherein the electric motor is driven by the phases from the inverter, a harnessing that connects the electric motor to the MDE component, wherein the harnessing includes a plurality of wires, and a plurality of sensors that are connected to the MDE component and are configured to sense voltage and current values in the MDE component between the plurality of switches of the inverter of the MDE component that is configured to drive the electric motor through the harnessing, wherein the MDE component is further configured to detect the fault in the electric motor system, apply a voltage and current according to a gate switching sequence for the phases of the electric motor system in response to detecting the fault, and isolate the fault within the electric motor system based on the sensed voltage and current values.

In addition to one or more of the features described above, or as an alternative, further embodiments may include a user interface connected to the MDE component that receives a user input and outputs fault isolation information and sensed voltage and current values, and a motor powered component that is connected to the electric motor.

In addition to one or more of the features described above, or as an alternative, further embodiments may include wherein the motor powered component is one selected from a group consisting of a pump, a compressor, an actuator, and a starter.

In addition to one or more of the features described above, or as an alternative, further embodiments may include, wherein the electric motor system is included in an aircraft.

In addition to one or more of the features described above, or as an alternative, further embodiments may include wherein the electric motor is a three-phase motor, wherein the plurality of switches include six switches arranged in pairs configured to create the three phases, and wherein the plurality of sensors include sensor detections points between the six switches arranged in pairs.

According to another embodiment, a computer program product to detect and isolate a fault in an electric motor system, the computer program product including a computer readable storage medium having program instructions embodied therewith is provided. The program instructions executable by a processor cause the processor to detect, at a motor drive electronics (MDE) component that is configured to drive an electric motor through a harnessing, the fault in the electric motor system, apply a voltage and current, at the MDE component, according to a gate switching sequence for all phases of the electric motor system in response to detecting the fault, sense voltage and current values in the MDE component between switches of an inverter of the MDE component, and isolate the fault within the electric motor system based on the sensed voltage and current values.

In addition to one or more of the features described above, or as an alternative, further embodiments may include wherein applying the voltage and current according to the gate switching sequence includes removing previous voltage and current across sensor detection points of sensors of the electric motor system in response to detecting the fault, and cycling the application of the voltage and current through the gate drives of the switches of the inverter that corresponds to each phase of the electric motor system.

In addition to one or more of the features described above, or as an alternative, further embodiments may include wherein if a voltage value of zero is sensed it is indicative of an open phase or failure of a switch of the inverter to turn on, and wherein if current is sensed and exceeds a ground fault limit (GFI), it is indicative of a gross ground fault.

In addition to one or more of the features described above, or as an alternative, further embodiments may include, wherein applying the voltage and current according to the gate switching sequence includes holding a single switch of the inverter on for an extended period to sense low level GFI, and closing the current loop for each phase one at a time using the other switches of the inverter, wherein the holding and closing is done for all combination of switches and phases.

In addition to one or more of the features described above, or as an alternative, further embodiments may include wherein isolating the fault based on the sensed voltage and current values further includes analyzing the sensed voltage and current values compared to known voltage and current values during a faultless normal operation state of the electric motor system, deriving differences between the sensed voltage and current values and the known voltage and current values based on the analysis, and looking up the differences in a truth table stored in the electric motor system that indicated fault location possibilities based on the detected differences.

In addition to one or more of the features described above, or as an alternative, further embodiments may include wherein removing voltage and current across sensor detection points includes sensor zeroing that includes removing the voltage and current from all gates in the MDE component, and removing the voltage and current from all sensors in the electric motor system.

In addition to one or more of the features described above, or as an alternative, further embodiments may include the computer program product further including additional program instructions embodied therewith, the additional program instructions executable by the processor to cause the processor to replace a line replaceable unit (LRU) of the electric motor system in response to the isolating of the fault being isolated to the LRU.

The foregoing features and elements may be combined in various combinations without exclusivity, unless expressly indicated otherwise. These features and elements as well as the operation thereof will become more apparent in light of the following description and the accompanying drawings. It should be understood, however, that the following description and drawings are intended to be illustrative and explanatory in nature and non-limiting.

### BRIEF DESCRIPTION OF THE DRAWINGS

The foregoing and other features, and advantages of the present disclosure are apparent from the following detailed description taken in conjunction with the accompanying drawings in which:
FIG. 1 depicts a block diagram of an electric motor system in accordance with one or more embodiments of the present disclosure;
FIG. 2 depicts another electric motor system in accordance with one or more embodiments of the present disclosure;
FIG. 3A depicts a graph of a gate switching sequence in accordance with one or more embodiments of the present disclosure;
FIG. 3B depicts a graph of phase voltage sensing during a non-faulted condition in accordance with one or more embodiments of the present disclosure;
FIG. 3C depicts a graph of phase current sending during a non-faulted condition in accordance with one or more embodiments of the present disclosure;
FIG. 4 depicts another electric motor system in accordance with one or more embodiments of the present disclosure;
FIG. 5 depicts a motor in accordance with one or more embodiments of the present disclosure;
FIG. 6A depicts a graph of an open wire fault condition on phase-a where a fault is isolated to being external to a MDE component in accordance with one or more embodiments of the present disclosure;
FIG. 6B depicts a graph of a faulted condition of a phase-α-hi gate being open, based on a response isolating the fault to within the MDE component in accordance with one or more embodiments of the present disclosure;
FIG. 6C depicts a graph of a faulted condition of a shunt inside a motor of 100Ω to ground whereas the GFI current is below the threshold and is isolated to being external to the MDE component in accordance with one or more embodiments of the present disclosure; and
FIG. 7 depicts a method of detecting and isolating a fault in an electric motor system in accordance with one or more embodiments of the present disclosure.

### DETAILED DESCRIPTION

As shown and described herein, various features of the disclosure will be presented. Various embodiments may have the same or similar features and thus the same or similar features may be labeled with the same reference numeral, but preceded by a different first number indicating the figure to which the feature is shown. Thus, for example, element "a" that is shown in FIG. X may be labeled "Xa" and a similar feature in FIG. Z may be labeled "Za." Although similar reference numbers may be used in a generic sense, various embodiments will be described and various features may include changes, alterations, modifications, etc. as will be appreciated by those of skill in the art, whether explicitly described or otherwise would be appreciated by those of skill in the art.

Embodiments described herein are directed to a system and method that effectively reduces the ambiguity of the failed component following a motor fault. In one embodiment a MDE component contains a 3-phase inverter (IGBT) which drives a 3-phase brushless dc (BLDC) motor over a harness length of 30m (100 feet). Various fault condition exist within this architecture which is common amongst motor drive systems which results in the loss or degradation of system function.

According to one or more embodiments, these faults and locations they occur include, but are not limited to, inverter faults, wiring faults, motor faults, and control sensor faults. Inverter faults include, but are not limited to gate drive open/short circuits, collector/emitter open/short circuits, phase to phase short circuit (aka. Shoot through), and phase to case (ground) short circuit. Wiring faults include, but are not limited to, phase to phase shunt/short/open circuit and phase to ground shunt/short circuit. Motor faults include, but are not limited to, phase to phase shunt/short circuit and phase to ground shunt/short circuit. Control sensor faults include, but are not limited to current sensor offset/gain shift.

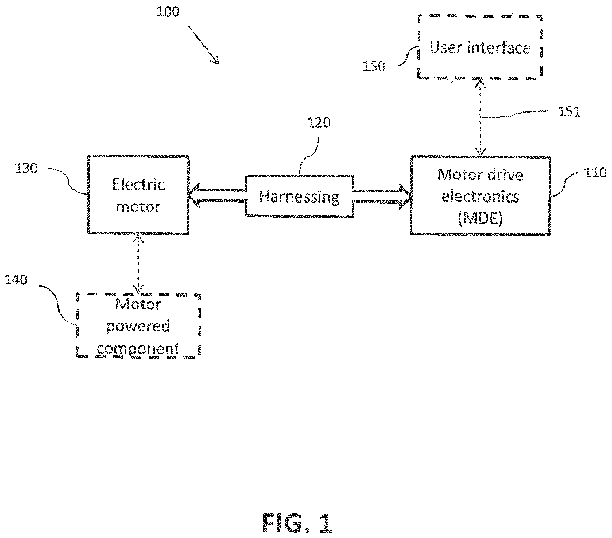

FIG. 1 depicts a block diagram of an electric motor system 100 in accordance with one or more embodiments of the present disclosure. The electric motor system 100 includes a motor drive electronics (MDE) component 110 and an electric motor 130. The MDE component 110 is communicatively and electrically connected to the electric motor 130 using a harnessing 120 which includes a plurality of wires.

According to one or more embodiments, the electric motor 130 may be any electric motor type and size depending on the specific motor powered component 140 that the electric motor 130 is powering. For example, motor powered component 140 may be a pump, compressor, actuator, and/or starter. Further, the motor powered component 140 may include a plurality of elements that the electric motor 130 is powering. For example, an aircraft's electric brake (eBrake) that includes eight actuators can be driven by the single MDE component 110 and electric motor 130.

According to one or more embodiments, the electric motor system 100 may also include a user interface 150 that is connected to the MDE component 110. The user interface 150 may receive and transmit signals 151 to and from the MDE component 110. For example, the user interface 150 may collect and transmit user input signals for controlling the electric motor 130. Further, the user interface 150 may receive information from the MDE component 110 about a detected fault and isolation of that fault. The MDE component 110 may also provide collected voltage and current data to the user interface 150 for displaying.

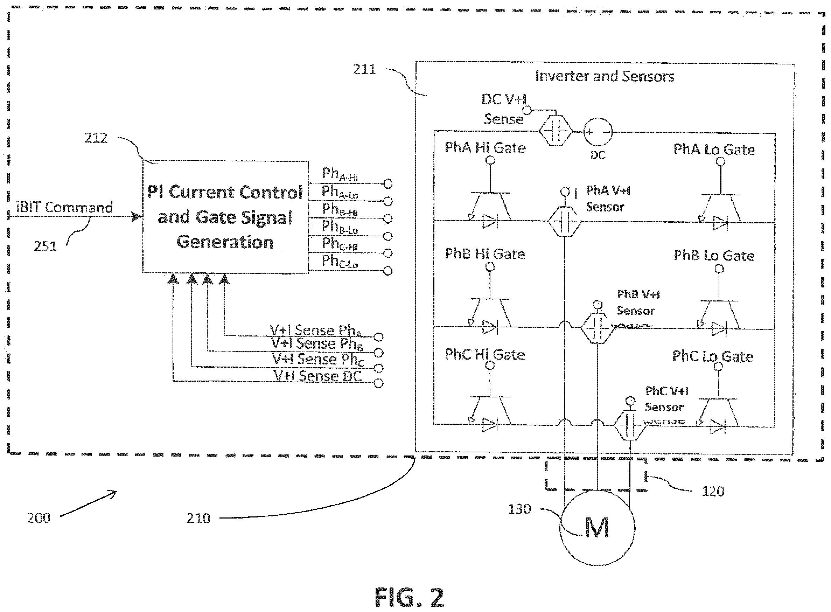

FIG. 2 depicts another electric motor system 200 in accordance with one or more embodiments of the present disclosure. The electric motor system 200 may include an MDE component 210 that is connected to an electric motor 130 using a harnessing 120. The electric motor system 200 includes both phase current and voltage sensing. Specifically, the motor drive system 200 includes the MDE component 210 that has the capability to sense both voltage and current as the phase exits the MDE component 210. The MDE component 210 further includes an inverter and sensors 211 and a PI current control and gate signal generation controller 212. Further, according to one or more embodiments, the MDE component 210 is configured to receive an Interruptive Built-In Test (iBiT) command. The iBiT command may be provided by a user using a user interface. The inverter and sensors 211 include an inverter with six switches arranged in pairs that provide a three-phase output for controlling a three-phase electric motor 130. According to other embodiments, the number of switches and phase may vary based on the electric motor 130 that is being controlled and powered. As shown the inverter and sensors include switches that are labeled according to their gate inputs which includes a Phase A (PhA) PhA Hi Gate switch and a PhA Lo Gate switch that are connected in series across a DC power supply with a PhA V+I sensor connected between them at the point where the motor 130 connects. Similarly, a PhB Hi Gate switch and a PhB Lo Gate switch are provided and are connected in series across the DC power supply with a PhB V+I sensor connected between them at the point where the motor 130 connects. Further, a PhC Hi Gate switch and a PhC Lo Gate switch are provided and are connected in series across the DC power supply with a PhC V+I sensor connected between them at the point where the motor 130 connects. The three pairs of switches are connected in parallel with each other as shown. Accordingly, this embodiment provides a three-phase motor 130 with variable phase control and power.

According to one or more embodiments, the electric motor system 200 can be operated as follows. When the electric motor system 200 is in a standby or initiated built in test (iBIT) mode, a specific switching sequence on the 3 phase IGBT H-bridge 211 can commence in order to assess the health of the internal power electronics 210 and the external harness 120 and electric motor 130. This switching sequence is referred to as inverter iBIT and can be entered following a control fault which may occur due to the aforementioned failure modes.

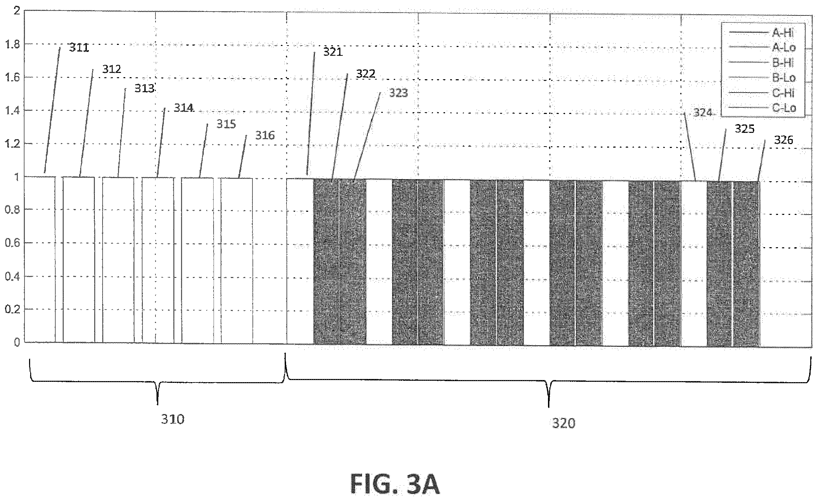

FIG. 3A depicts a graph of a gate switching sequence implemented by a switching method in accordance with one or more embodiments of the present disclosure. The switching method first nulls the voltage and current sensors such that no gates are driven which is sometimes called sensor zeroing. The method then quickly cycles through the gate drives of the six switches of the inverter individually and senses current and voltage on all of the phases. The six switches are the PhA Hi Gate switch, PhA Lo Gate switch, PhB Hi Gate switch, PhB Lo Gate switch, PhC Hi Gate switch, and PhC Lo Gate switch as shown in FIG. 2. The six input signals that are provided at the gates of the six switches are A-Hi, A-Lo, B-Hi, B-Lo, C-Hi, and C-Lo, respectively. These initial inputs are shown in FIG. 3A. As shown the input signal can be provided individually for a single pulse during a first period 310. Combination of input signals are then provided during a second period 320 as shown in FIG. 3A and discussed below. Looking specifically at the first period 310, FIG. 3A shows the inputs A-Hi (311), A-Lo (312), B-Hi (313), B-Lo (314), C-Hi (315), and C-Lo (316) being individually cycled in that order. According to other embodiments, other orders may be provided in which the inputs are cycled.

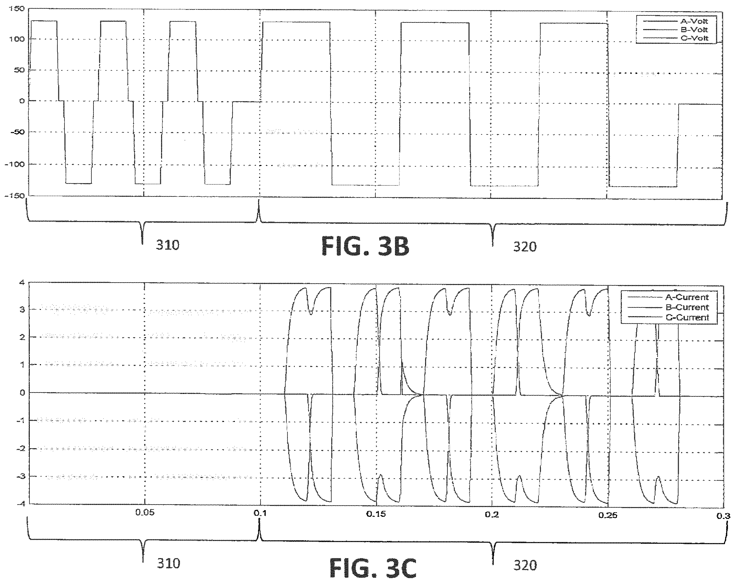

In accordance with one or more embodiments, this initial zero sequence results from the first period 310 in the link voltage sensed on all phases (either +/-) showing continuity, as shown in the phase voltages of FIG. 3B, and no sensed current (i.e. no ground path), as shown in the phase voltages of FIG. 3C. In more detail, FIG. 3B depicts a graph of phase voltage sensing during a non-faulted condition in accordance with one or more embodiments of the present disclosure. FIG. 3C depicts a graph of phase current sensing during a non-faulted condition in accordance with one or more embodiments of the present disclosure. Further, according to one or more embodiments, if a zero voltage value is sensed it is indicative of an open phase or failure of the switch to turn on. If current is sensed and exceeds the ground fault limit (GFI), it is indicative of a gross ground fault.

Going back to FIG. 3A, the next operation shown during the second period 320 is holding a single switch on for an extended period (e.g. phase A-Hi) to sense low level GFI and then closing the PI current loop for a particular phase command using a phase pair that includes another two phases one at a time (e.g. phase B-lo 3.5A, then phase C-lo 3.5A). While the corresponding phase pair is closing the loop the phase held hi (phA-hi in this example) acts as a check of the ability of the other phases to close the loop. For example, looking at FIG. 3A, the A-Hi 321 is turned on and remains held at the start of the second period 320. While A-Hi 321 is on, B-Lo 322 is activated for a duration of time. Once B-Lo 322 is deactivated, C-Lo 323 is then activated for the remaining time that A-Hi 321 is on. Other combination are also implemented to test different path as shown. For example, looking at FIG. 3A, the C-Lo 324 is turned on and remains held toward the end of the second period 320. While C-Lo 323 is on, A-Hi 325 is activated for a duration of time. Once A-Hi 325 is deactivated, B-Hi 326 is then activated for the remaining time that C-Lo 324 is on. Other combinations are shown, and in accordance with one or more embodiments, other combination may be provided to make up the switching sequence.

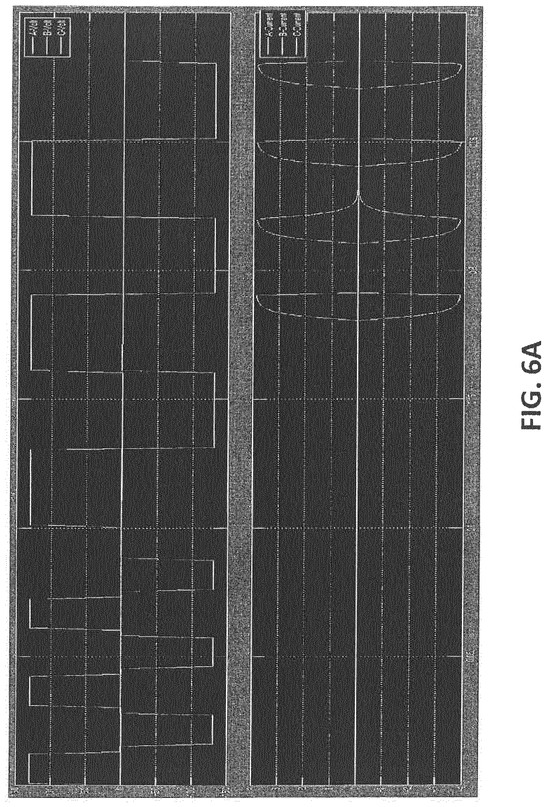

Looking again at FIG. 3B, Fig. 3B depicts a graph of phase voltage sensing during a non-faulted condition in response to the inputs shown in FIG. 3A explained above. Further, FIG. 3C depicts a graph of phase current sensing during a non-faulted condition in response to the inputs shown in FIG. 3A in accordance with one or more embodiments of the present disclosure. Thus, later when a fault condition occurs, the same inputs from the switching/cycling sequence shown in FIG. 3A are input, but a different voltage and/or current values will be plotted on a graph that will be created that can be compared to these non-fault graphs. The differences can be determined and based on the differences, different faults and fault locations can be determined. Examples of such fault graphs are provided in FIGs. 6A through 6C.

Further according to one or more embodiments, once all combinations have been completed, a voting scheme may occur. The voting scheme that occurs determines which phase sensor (if any) is out of calibration and requires adjustment for optimal motor control.

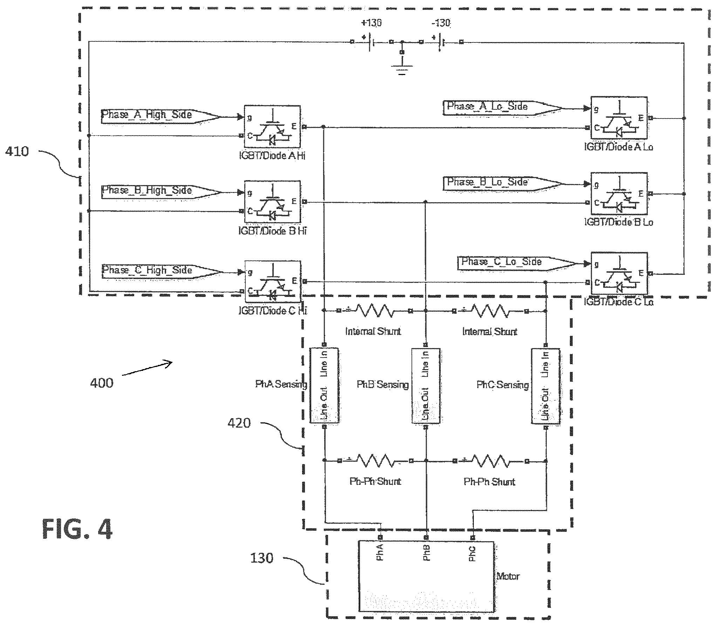

FIG. 4 depicts another electric motor system 400 in accordance with one or more embodiments of the present disclosure. As shown the electric motor system 400 includes a MPE component 410, an electric motor 130 and a harnessing 420. In this embodiment the MPE component 410 is substantially similar to the MPE component 210 of FIG. 2. However, as shown the sensor detection points and sensors are not provided in the MPE component 210. Rather, as shown the sensing elements are included in the harnessing 420. Further, the harnessing 420 may include internal shunts and Ph-Ph shunts as shown. The sensing elements may be included anywhere along the harnessing 420 wiring provided between the MPE component 410 and the electric motor 130. The sensing elements are configured to collect voltage and current values and transmit them back to the MPE component 410 for processing.

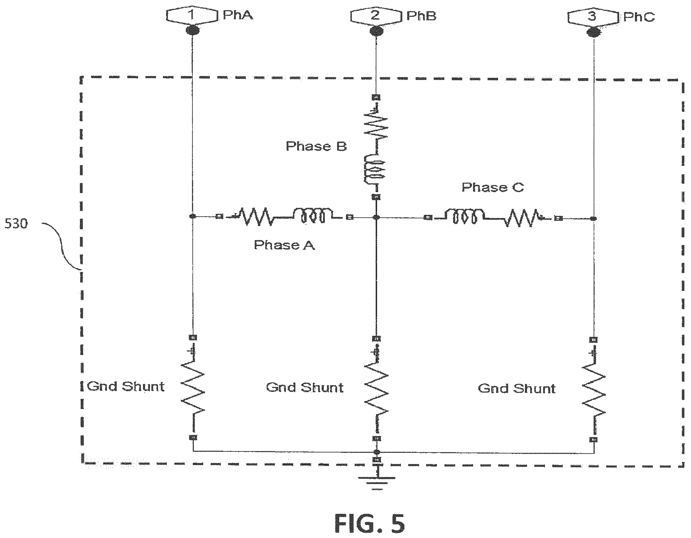

FIG. 5 depicts an electric three-phase motor 530 in accordance with one or more embodiments of the present disclosure. As shown the motor 530 includes a Phase A, Phase B, and Phase 3 along with shunts to Gnd. The motor 530 has connections PhA, PhB, and PhC that connect the motor 530 to the MPE component inverter than provides the different voltage and current values in phases. According to other embodiments, other electric motor types can be provided and used in with electric motor system and method.

According to one or more embodiments, a number of different voltage and current values can be sensed and collected during times when different types of fault conditions are present within an electric motor system. These voltage and current values can be graphed and compared to normal operating values of the same. The different distinctions and/or wave patterns can then be mapped to a known fault condition that creates those response values. For example FIGs. 6A through 6C show specific examples of such fault detections but are not meant to be limiting as a large variety of other patterns may be provided and detected that indicate many different faults that can be present in the electric motor system.

For example, FIG. 6A depicts a graph of an open wire fault condition on phase-a where a fault is isolated to being external to a MDE component in accordance with one or more embodiments of the present disclosure. As show, by repeating the switch sequence above as shown in FIG. 2A with an open wire fault condition on phase a, the method clearly identifies the fault and removes ambiguity by isolating it to the proper LRU, namely the harness. For example, the graph of 6A is compared with the graphs of FIGs. 3B and 3C that show the response when no fault is present. The difference between the graph of 6A and the graphs of 3B and 3C can be detected and collected. Different faults will generate these differences which allows for their detection. This can be achieved by storing the fault with associated difference information in a truth table or other form that can be referred to for comparison to identify the currently detected faults.

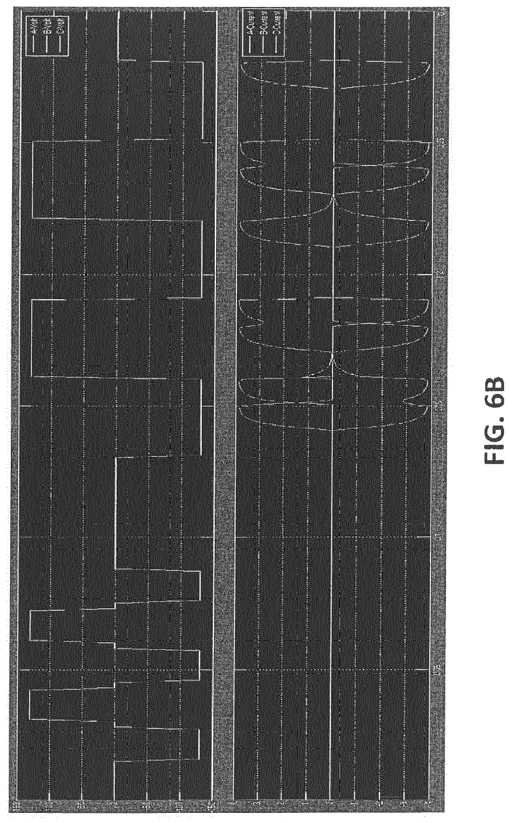

FIG. 6B depicts an example of another graph of a faulted condition of a phase-α-hi gate being open, based on a response isolating the fault to within the MDE component in accordance with one or more embodiments of the present disclosure. As show, the faulted condition is that of the phase α-hi gate being opened, which effectively disables its ability to turn on. As shown the method isolates the fault to within the MDE unit. Similarly, the graph of 6B is compared to the no-fault graphs shown in FIGs. 3B and 3C and the difference are identified, stored, and then used to identify the fault that the graph of FIG. 6B corresponds to.

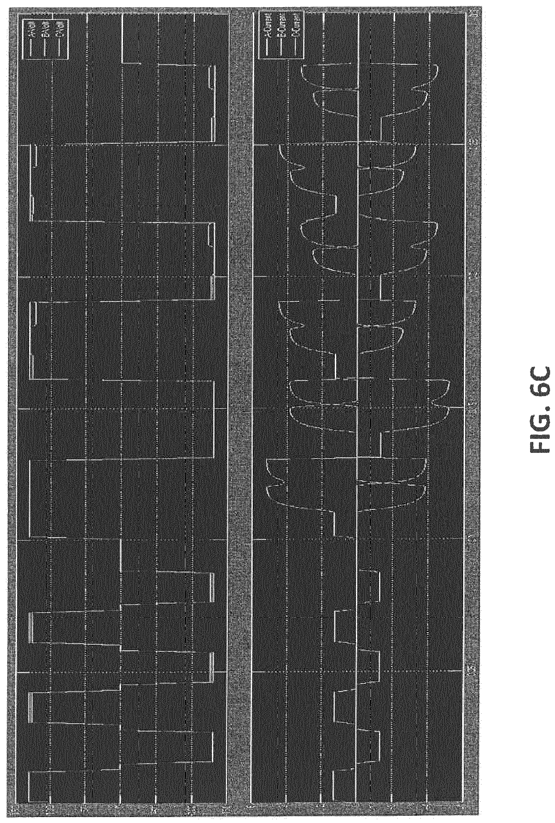

FIG. 6C depicts a graph of a faulted condition of a shunt inside a motor of 100Ω to ground whereas the GFI current is below the threshold and is isolated to being external to the MDE component in accordance with one or more embodiments of the present disclosure. This fault is detected by comparing the graph of FIG. 6C with the no-fault graphs for the same switching sequence as shown in FIGs. 3B and 3C in order to identify the differences which can be used to identify the corresponding fault.

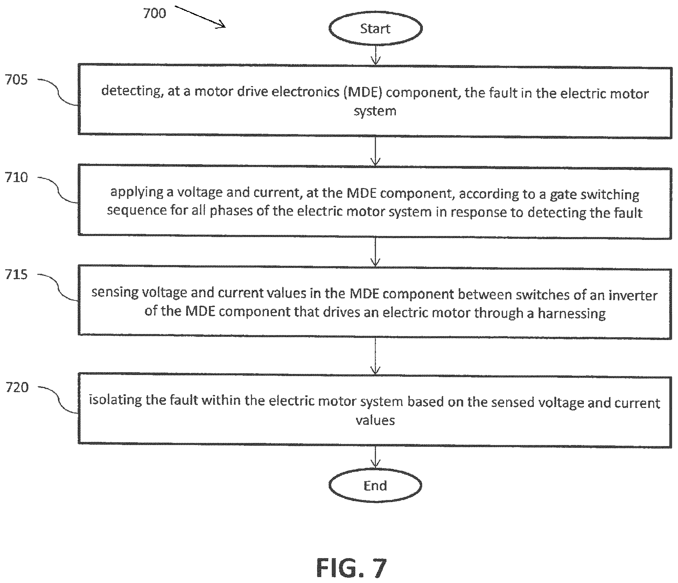

FIG. 7 depicts a method 700 of detecting and isolating a fault in an electric motor system in accordance with one or more embodiments of the present disclosure. The method 700 includes detecting, at a motor drive electronics (MDE) component, the fault in the electric motor system (operation 705). The method 700 also includes applying a voltage and current, at the MDE component, according to a gate switching sequence for all phases of the electric motor system in response to detecting the fault (operation 710). Further, the method includes sensing voltage and current values in the MDE component between switches of an inverter of the MDE component that drives an electric motor through a harnessing (operation 715). The method also includes isolating the fault within the electric motor system based on the sensed voltage and current values (operation 720).

According to another embodiment, applying the voltage and current according to the gate switching sequence includes removing previous voltage and current across sensor detection points of sensors of the electric motor system in response to detecting the fault. Applying the voltage and current also includes cycling the application of the voltage and current through gate drives of the switches of the inverter that corresponds to each phase of the electric motor system. According to another embodiment, applying the voltage and current according to the gate switching sequence includes holding a single switch of the inverter on for an extended period to sense low level GFI, and closing the current loop for each phase one at a time using the other switches of the inverter. The holding and closing is done for all combination of switches and phases.

According to another embodiment, isolating the fault based on the sensed voltage and current values further includes analyzing the sensed voltage and current values compared to known voltage and current values during a faultless normal operation state of the electric motor system, deriving differences between the sensed voltage and current values and the known voltage and current values based on the analysis, and looking up the differences in a truth table stored in the electric motor system that indicated fault location possibilities based on the detected differences. According to another embodiment, removing voltage and current across sensor detection points includes sensor zeroing that includes removing the voltage and current from all gates in the MDE component, and removing the voltage and current from all sensors in the electric motor system.

According to another embodiment, if a voltage value of zero is sensed it is indicative of an open phase or failure of a switch of the inverter to turn on. Further, according to another embodiment, if current is sensed and exceeds a ground fault limit (GFI), it is indicative of a gross ground fault. According to another embodiment, the method can further include replacing a line replaceable unit (LRU) of the electric motor system in response to the isolating of the fault being isolated to the LRU. According to another embodiment, the method and electric motor system are implemented and included in an aircraft.

According to one or more embodiments, the ability to isolate the location of a fault can help a user not blame fault free components of the electric motor system. For example the fault isolation can help a user not blame an expensive sensor, or controller, because the isolation method this provides strong evidence that the fault is originating from somewhere else in the system such as, either wiring harnessing, in the motor, or elsewhere in the MPE component.

While the present disclosure has been described in detail in connection with only a limited number of embodiments, it should be readily understood that the present disclosure is not limited to such disclosed embodiments. Rather, the present disclosure can be modified to incorporate any number of variations, alterations, substitutions, combinations, sub-combinations, or equivalent arrangements not heretofore described, but which are commensurate with the scope of the present invention as defined by the claims. Additionally, while various embodiments of the present disclosure have been described, it is to be understood that aspects of the present disclosure may include only some of the described embodiments.

The terminology used herein is for the purpose of describing particular embodiments only and is not intended to be limiting. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

The corresponding structures, materials, acts, and equivalents of all means or step plus function elements in the claims below are intended to include any structure, material, or act for performing the function in combination with other claimed elements as specifically claimed. The description has been presented for purposes of illustration and description, but is not intended to be exhaustive or limited to the embodiments in the form disclosed. Many modifications and variations will be apparent to those of ordinary skill in the art without departing from the scope of the claims. The embodiments were chosen and described in order to best explain the principles of the disclosure and the practical application, and to enable others of ordinary skill in the art to understand various embodiments with various modifications as are suited to the particular use contemplated.

The present embodiments may be a system, a method, and/or a computer program product at any possible technical detail level of integration. The computer program product may include a computer readable storage medium (or media) having computer readable program instructions thereon for causing a processor to carry out aspects of the present disclosure.

The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network and/or a wireless network. The network may comprise copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device.

Computer readable program instructions for carrying out operations of the present disclosure may be assembler instructions, instruction-set-architecture (ISA) instructions, machine instructions, machine dependent instructions, microcode, firmware instructions, state-setting data, configuration data for integrated circuitry, or either source code or object code written in any combination of one or more programming languages, including an object oriented programming language such as Java, Smalltalk, C++, or the like, and conventional procedural programming languages, such as the "C" programming language or similar programming languages. The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the present disclosure.

Aspects of the present invention are described herein with reference to flowchart illustrations and/or block diagrams of methods, apparatus (systems), and computer program products according to embodiments. It will be understood that each block of the flowchart illustrations and/or block diagrams, and combinations of blocks in the flowchart illustrations and/or block diagrams, can be implemented by computer readable program instructions.

These computer readable program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks. These computer readable program instructions may also be stored in a computer readable storage medium that can direct a computer, a programmable data processing apparatus, and/or other devices to function in a particular manner, such that the computer readable storage medium having instructions stored therein comprises an article of manufacture including instructions which implement aspects of the function/act specified in the flowchart and/or block diagram block or blocks.

The computer readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowchart and/or block diagram block or blocks.

The flowchart and block diagrams in the Figures illustrate the architecture, functionality, and operation of possible implementations of systems, methods, and computer program products according to various embodiments. In this regard, each block in the flowchart or block diagrams may represent a module, segment, or portion of instructions, which comprises one or more executable instructions for implementing the specified logical function(s). In some alternative implementations, the functions noted in the blocks may occur out of the order noted in the Figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

The descriptions of the various embodiments have been presented for purposes of illustration, but are not intended to be exhaustive or limited to the embodiments disclosed. Many modifications and variations will be apparent to those of ordinary skill in the art without departing from the scope of the claims. The terminology used herein was chosen to best explain the principles of the embodiments, the practical application or technical improvement over technologies found in the marketplace, or to enable others of ordinary skill in the art to understand the embodiments disclosed herein.

Accordingly, the present disclosure is not to be seen as limited by the foregoing description, but is only limited by the scope of the appended claims.

## Claims

1. A method of detecting and isolating a fault in an electric motor system, the method comprising:
detecting, at a motor drive electronics (MDE) component (110) that is configured to drive an electric motor (130) through a harnessing (120), the fault in the electric motor system;
applying a voltage and current, at the MDE component, according to a gate switching sequence for all phases of the electric motor system in response to detecting the fault;
sensing voltage and current values in the MDE component between switches of an inverter of the MDE component; and
isolating the fault within the electric motor system based on the sensed voltage and current values.

2. The method of claim 1, wherein applying the voltage and current according to the gate switching sequence comprises:
removing previous voltage and current across sensor detection points of sensors of the electric motor system in response to detecting the fault; and
cycling the application of the voltage and current through gate drives of the switches of the inverter that corresponds to each phase of the electric motor system.

3. The method of claim 2,
wherein if a voltage value of zero is sensed it is indicative of an open phase or failure of a switch of the inverter to turn on, and whe
rein if current is sensed and exceeds a ground fault limit (GFI), it is indicative of a gross ground fault.

4. The method of claim 1, wherein applying the voltage and current according to the gate switching sequence comprises:
holding a single switch of the inverter on for an extended period to sense low level GFI; and
closing the current loop for each phase one at a time using the other switches of the inverter,
wherein the holding and closing is done for all combination of switches and phases.

5. The method of claim 1, wherein isolating the fault based on the sensed voltage and current values further comprises:
analyzing the sensed voltage and current values compared to known voltage and current values during a faultless normal operation state of the electric motor system;
deriving differences between the sensed voltage and current values and the known voltage and current values based on the analysis; and
looking up the differences in a truth table stored in the electric motor system that indicated fault location possibilities based on the detected differences.

6. The method of claim 2, wherein removing voltage and current across sensor detection points includes sensor zeroing that comprises:
removing the voltage and current from all gates in the MDE component; and
removing the voltage and current from all sensors in the electric motor system.

7. The method of claim 1, further comprising:
replacing a line replaceable unit (LRU) of the electric motor system in response to the isolating of the fault being isolated to the LRU.

8. The method of claim 1, wherein the electric motor system is included in an aircraft.

9. An electric motor system for detecting and isolating a fault, the system comprising:
a motor drive electronic (MDE) component (110) comprising an inverter (211) with a plurality of switches configured to switch between phases;
an electric motor (130) connected to the MDE component, wherein the electric motor is driven by the phases from the inverter;
a harnessing (120) that connects the electric motor to the MDE component, wherein the harnessing includes a plurality of wires; and
a plurality of sensors (211) that are connected to the MDE component and are configured to sense voltage and current values in the MDE component between the plurality of switches of the inverter of the MDE component that is configured to drive the electric motor through the harnessing,
wherein the MDE component is further configured to detect the fault in the electric motor system, apply a voltage and current according to a gate switching sequence for the phases of the electric motor system in response to detecting the fault, and isolate the fault within the electric motor system based on the sensed voltage and current values.

10. The electric motor system of claim 9, further comprising:
a user interface (150) connected to the MDE component that receives a user input and outputs fault isolation information and sensed voltage and current values; and
a motor powered component (140) that is connected to the electric motor.

11. The electric motor system of claim 10, wherein the motor powered component is one selected from a group consisting of a pump, a compressor, an actuator, and a starter.

12. The electric motor system of any of claims 9 to 11, wherein the electric motor system is included in an aircraft.

13. The electric motor system of any of claims 9 to 12,
wherein the electric motor is a three-phase motor,
wherein the plurality of switches include six switches arranged in pairs configured to create the three phases, and
wherein the plurality of sensors include sensor detections points between the six switches arranged in pairs.
